(19) Europäisches Patentamt / European Patent Office / Office européen des brevets

(11) **EP 4 459 687 A1**

(12) **EUROPEAN PATENT APPLICATION**

(43) Date of publication:
06.11.2024 Bulletin 2024/45

(21) Application number: 24172210.7

(22) Date of filing: 24.04.2024

(51) International Patent Classification (IPC):
*H01L 33/54* (2010.01)   *H01L 33/60* (2010.01)
*H01L 33/50* (2010.01)

(52) Cooperative Patent Classification (CPC):
**H01L 33/60; H01L 33/54;** H01L 2933/0091

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 25.04.2023 US 202363461616 P
29.02.2024 US 202463559434 P
18.04.2024 US 202418639194

(71) Applicant: **Seoul Semiconductor Co., Ltd.**
**Gyeonggi-do 15429 (KR)**

(72) Inventors:
• **JANG, BoRaml**
**15429 Ansan-si (KR)**
• **CHOI, EunMi**
**15429 Ansan-si (KR)**

(74) Representative: **Stolmár & Partner**
**Patentanwälte PartG mbB**
**Blumenstraße 17**
**80331 München (DE)**

(54) **LIGHT EMITTING DEVICE**

(57) Disclosed is a light emitting device. The light emitting device includes a light emitting source including a light emitting semiconductor device; a reflector disposed on a side region of the light emitting source while at least partially adjoining the side region of the light emitting source; a front-light extractor disposed on the light emitting source and the reflector and including a body including a first convex shape; a wavelength conversion layer disposed in at least a region on a light path of the light emitting source; and a substrate on which the light emitting source, the reflector and the front-light extractor are disposed, wherein the reflector comprises a first reflective surface formed in at least a region thereof and including a second convex shape, the second convex shape of the first reflective surface has a radius of curvature greater than or equal to a radius of curvature of the first convex shape of the front-light extractor.

【FIG. 2】

EP 4 459 687 A1

## Description

[Technical Field]

The following description relates to a light emitting device, more particularly to a light emitting device including a light emitting semiconductor device.

[Background Art]

A light emitting diode (LED) is an inorganic semiconductor device that emits light generated through recombination of electrons and holes, and has recently been used in many fields, such as display devices, vehicular lamps, general lighting, and the like. Since light emitting diodes have long lifespan, low power consumption, and fast response time, light emitting devices including such light emitting diodes are expected to replace typical light sources.

A light emitting diode package produced and implemented in packaged form includes a light emitting diode chip, a substrate for mounting the light emitting diode chip, electrodes for applying electric current to the light emitting diode chip, moldings for protecting the light emitting diode chip, and optical lenses.

For light emitting diode packaging, it is an important issue to extract as much light as possible from the light emitting diode chip and various studies have been made to further improve light extraction efficiency.

[Disclosure]

[Technical Problem]

Exemplary embodiments of the present invention provide a light emitting device that can reduce light loss while improving light extraction efficiency.

Exemplary embodiments of the present invention provide a light emitting device that can delay moisture penetration while improving reliability through increase in length of a moisture penetration path.

Exemplary embodiments of the present invention provide a light emitting device that can reduce stress caused by external pressure while improving structural stability.

Exemplary embodiments of the present invention provide a light emitting device that uses a reflector to improve light stability while reducing yellowing and discoloration.

Exemplary embodiments of the present invention provide a light emitting device that can improve light output by reducing side emitting light loss of a light emitting semiconductor device.

Exemplary embodiments of the present invention provide a light emitting device that has high color purity by reducing chromatic aberration of side emitting light of a light emitting source.

[Technical solution]

According to one or more embodiments of the present disclosure, a light emitting device may include: a light emitting source including a light emitting semiconductor; a reflector disposed on a side region of the light emitting source while at least partially adjoining the side region of the light emitting source; a front-light extractor disposed on the light emitting source and the reflector and including a body including a first curved shape; a wavelength conversion layer disposed in at least a region on a light path of the light emitting source; and a substrate on which the light emitting source, the reflector, and the front-light extractor are disposed. The light emitting source may include a side light extractor disposed between the light emitting source and the reflector, in which the side light extractor includes a second curved shape on a surface thereof and a maximum radius of curvature of the second curved shape may be less than a radius of curvature of the first curved shape of the front-light extractor.

A distance from an upper surface of the wavelength conversion layer to an apex a center of the first curved shape may correspond to the radius of curvature of the first curved shape.

The wavelength conversion layer may be a film or sheet type and a thickness deviation of the wavelength conversion layer on an upper surface of the light emitting source may be less than 10%. at least one side region of the light emitting source may have a length d1 in a lateral direction and the wavelength conversion layer may have a length d2 in the lateral direction, in which the length d1 may be less than or equal to the length d2.

A ratio of an area of the wavelength conversion layer to an area of the light emitting source may be 150% or less.

Light emitted from the light emitting source may have a first wavelength band and the wavelength conversion layer may include a first type of particles converting a fraction of light having a wavelength in the first wavelength band into light having a wavelength in a second wavelength band, in which wavelengths in the first wavelength band may be shorter than wavelengths in the second wavelength band.

The wavelength conversion layer may further include a second type of particles converting a fraction of light having a wavelength in the first wavelength band into light having a wavelength in a third wavelength band, in which wavelengths in the third wavelength band may be longer than wavelengths in the second wavelength band.

The side light extractor may have a higher transmittance than the reflector.

The side light extractor may include a first side light extractor disposed at a side of the light emitting source and a second side light extractor disposed at the other side of the light emitting source, and a difference between a maximum height of the first side light extractor from the substrate and a maximum height of the second side light extractor from the substrate may be about 10%, and specifically, may be 10% or less.

The side light extractor may include a maximum thickness not exceeding a thickness of the light emitting source.

The reflector may include a first reflective surface adjoining at least one surface of the front-light extractor and a second reflective surface adjoining at least one surface of the side light extractor, in which the first and second reflective surfaces may be asymmetrical.

A maximum thickness of the second reflective surface from an upper surface of the substrate may be less than a maximum thickness of the first reflective surface therefrom.

At least a region of the first reflective surface may be flush with or higher than an upper surface of the wavelength conversion layer.

The reflector may include a linear region adjoining the wavelength conversion layer, in which the linear region may have a height corresponding to a thickness of the wavelength conversion layer.

The reflector may include a first reflector formed at a side of the light emitting source and a second reflector formed at the other side of the light emitting source, in which the first reflector and the second reflector may have different widths with reference to an imaginary horizontal line from the upper surface of the substrate.

According to one or more embodiments of the present disclosure, a light emitting device includes: a light emitting source including a light emitting semiconductor device; a reflector disposed on a side region of the light emitting source while at least partially adjoining the side region of the light emitting source; a front-light extractor disposed on the light emitting source and the reflector; and a wavelength conversion layer disposed in at least a region on a light path of the light emitting source; a side light extractor disposed between the light emitting source and the reflector; and a substrate on which the light emitting source, the reflector, and the front-light extractor are disposed, wherein the reflector further includes a first reflective surface including at least one surface adjoining the front-light extractor and a second reflective surface including at least one surface adjoining the side light extractor, and has a greater radius of curvature than the first reflective surface and the second reflective surface.

The first reflective surface may include a decreasing or saturated slope with decreasing distance to the light emitting source in a lateral direction.

The wavelength conversion layer may be a film or sheet type and a thickness deviation of the wavelength conversion layer on an upper surface of the light emitting source may be less than 10%.

at least one side region of the light emitting source may have a length $d1$ in a lateral direction and the wavelength conversion layer may include a length $d2$ in the lateral direction, in which the length $d1$ may be less than or equal to the length $d2$.

A ratio of a region of the wavelength conversion layer to a region of the light emitting source may be 150% or less.

Light emitted from the light emitting source may have a first wavelength band and the wavelength conversion layer may include a first type of particles converting a fraction of the light having a wavelength in the first wavelength band into light having a wavelength in a second wavelength band, in which the first wavelength band may be a shorter wavelength region than the second wavelength band.

The wavelength conversion layer may further include a second type of particles converting a fraction of the light having a wavelength in the first wavelength band into light having a wavelength in a third wavelength band, in which the third wavelength band may be a longer wavelength region than the second wavelength band.

The side light extractor may include a first side light extractor disposed at a side of the light emitting source and a second side light extractor disposed at the other side of the light emitting source, in which a difference between a maximum height of the first side light extractor from the substrate and a maximum height of the second side light extractor from the substrate may be about 10%, and specifically, may be 10% or less.

The side light extractor may include a higher transmittance than the reflector.

The side light extractor may include a maximum thickness not exceeding a thickness of the light emitting source.

A maximum height of the second reflective surface from the substrate may be less than a maximum height of the first reflective surface.

At least a region of the first reflective surface may be flush with or higher than an upper surface of the wavelength conversion layer.

The reflector may include a first reflector formed at a side of the light emitting source and a second reflector formed at the other side of the light emitting source, in which the first reflector and the second reflector may include different widths with reference to an imaginary horizontal line from the upper surface of the substrate.

The reflector may include a first reflector and a second reflector formed at both sides of the light emitting source, in which the first reflector and the second reflector may include different widths with reference to an imaginary horizontal line from the upper surface of the substrate.

According to one or more embodiments of the present disclosure, a light emitting device includes: a light emitting source including a light emitting semiconductor; a reflector disposed on a side region of the light emitting source while at least partially adjoining the side region of the light emitting source; a front-light extractor including a body covering the light emitting source and the reflector; a wavelength conversion layer disposed in at least a region on a light path of the light emitting source;

a side light extractor disposed between the light emitting source and the reflector and including a first radius of curvature; and a substrate on which the light emitting source, the reflector, and the front-light extractor are disposed. The front-light extractor may further include a spacer extending from a lower distal end of the body in a vertical direction and a neck between the spacer and the body, in which the neck may include an inclined region gradually narrowing toward a center of the body and a region of the inclined region may have a second radius of curvature.

The first radius of curvature may be greater than or equal to the second radius of curvature.

The wavelength conversion layer may be a film or sheet type and a thickness deviation of the wavelength conversion layer on an upper surface of the light emitting source may be less than 10%.

At least one side region of the light emitting source may include a length d1 in a lateral direction and the wavelength conversion layer may include a length d2 in the lateral direction, in which the length d1 may be less than or equal to the length d2.

A ratio of an area of the wavelength conversion layer to an area of the light emitting source may be 150% or less.

Light emitted from the light emitting source may have a first wavelength band and the wavelength conversion layer may include a first type of particles converting a fraction of the light having a wavelength in the first wavelength band into light having a wavelength in a second wavelength band, in which the first wavelength band may be a shorter wavelength region than the second wavelength band.

The wavelength conversion layer may further include a second type of particles converting a fraction of the light having a wavelength in the first wavelength band into light having a wavelength in a third wavelength band, in which the third wavelength band may be a longer wavelength region than the second wavelength band.

The side light extractor may include a first side light extractor disposed on a side of the light emitting source and a second side light extractor disposed at the other side of the light emitting source, in which a difference between a maximum height of the first side light extractor from the substrate and a maximum height of the second side light extractor from the substrate may be about 10%, and specifically, may be 10% or less.

The side light extractor may have a higher transmittance than the reflector.

The side light extractor may include a maximum thickness not exceeding a thickness of the light emitting semiconductor device.

An inclined region of the side light extractor may start at a height lower than 1/5 of the thickness of the light emitting source from the upper surface of the substrate.

The side light extractor may have a light transmittance of 70% or more.

A starting point of the side light extractor from the upper surface of the substrate may be lower than an active region of the light emitting source.

The reflector may include a linear region adjoining the wavelength conversion layer, in which the linear region may have a height corresponding to a thickness of the wavelength conversion layer.

The reflector may include a first reflector formed at a side of the light emitting source and a second reflector formed at the other side of the light emitting source, in which the first reflector and the second reflector may include different widths with reference to an imaginary horizontal line from the upper surface of the substrate.

According to one or more embodiments of the present disclosure, a light emitting device includes: a light emitting source including a light emitting semiconductor device; a reflector disposed on a side region of the light emitting source while at least partially adjoining the side region of the light emitting source; a front-light extractor including a body covering the light emitting source and the reflector; a wavelength conversion layer disposed in at least a region on a light path of the light emitting source; a side light extractor disposed between the light emitting source and the reflector; and a substrate on which the light emitting source, the reflector, and the front-light extractor are disposed. When the front-light extractor includes a first radius of curvature R1, the wavelength conversion layer includes a first thickness w1, and the light emitting source includes a second thickness w2, the radius of curvature R1 of the front-light extractor may satisfy a relationship $R1 \geq (w1 + w2) \times 4$.

The second thickness w2 may be greater than the first thickness w1.

The wavelength conversion layer may be a film or sheet type and a thickness deviation of the wavelength conversion layer on an upper surface of the light emitting source may be less than 10%.

at least one of side region of the light emitting source may include a length d1 in a lateral direction and the wavelength conversion layer may include a length d2 in the lateral direction, in which the length d1 may be less than or equal to the length d2.

A ratio of an area of the wavelength conversion layer to an area of the light emitting source may be 150% or less.

Light emitted from the light emitting source may have a first wavelength band and the wavelength conversion layer may include a first type of particles converting a fraction of the light having a wavelength in the first wavelength band into light having a wavelength in a second wavelength band, in which the first wavelength band may be a shorter wavelength region than the second wavelength band.

The wavelength conversion layer may further include a second type of particles converting a fraction of the light having a wavelength in the first wavelength band into light having a wavelength in a third wavelength band, in which the third wavelength band may be a longer wavelength region than the second wavelength band.

The side light extractor may include a first side light extractor disposed on a side of the light emitting source and a second side light extractor disposed at the other side of the light emitting source, in which a difference between a maximum height of the first side light extractor from the substrate and a maximum height of the second side light extractor from the substrate may be about 10%, and specifically, may be 10% or less.

The side light extractor may have a higher transmittance than the reflector.

The side light extractor may have a maximum thickness not exceeding a thickness of the light emitting source.

An inclined region of the side light extractor may start at a height lower than 1/5 of the thickness of the light emitting source from the upper surface of the substrate.

A starting point of the side light extractor from the upper surface of the substrate may be lower than an active region of the light emitting source.

The side light extractor may have a light transmittance of 70% or more.

The reflector may include a linear region adjoining the wavelength conversion layer, in which the linear region may include a height corresponding to a thickness of the wavelength conversion layer.

According to one or more embodiments of the present disclosure, a light emitting device includes: a light emitting source including a light emitting semiconductor device; a reflector disposed on a side region of the light emitting source while at least partially adjoining the side region of the light emitting source; a front-light extractor disposed on the light emitting source and the reflector and including a body including a first radius of curvature R1; a wavelength conversion layer disposed in at least a region on a light path of the light emitting source and including at least one side including a length d2; a side light extractor disposed between the light emitting source and the reflector; and a substrate including the light emitting source, the reflector and the front-light extractor mounted on an upper surface thereof. The first radius of curvature R1 may be optimized according to a size of the wavelength conversion layer and may satisfy a relational inequality $-0.4447k^2 + 1.0116k + 0.4534 \geq 0.8$ where k denotes a ratio of the radius of curvature R1 of the front-light extractor to the length d2 of the wavelength conversion layer.

A difference between the first radius of curvature R1 and a distance from an upper surface of the light emitting source to a center of the body of the front-light extractor may be less than 10%.

The wavelength conversion layer may be a film or sheet type and a thickness deviation of the wavelength conversion layer on an upper surface of the light emitting source may be less than 10%.

At least one of side region of the light emitting source may include a length d1 in a lateral direction and the wavelength conversion layer may include a length d2 in the lateral direction, in which the length d1 may be less than or equal to the length d2.

A ratio of an area of the wavelength conversion layer to an area of the light emitting source may be 150% or less.

Light emitted from the light emitting source may have a first wavelength band and the wavelength conversion layer may include a first type of particles converting a fraction of the light having a wavelength in the first wavelength band into light having a wavelength in a second wavelength band, in which the first wavelength band may be a shorter wavelength region than the second wavelength band.

The wavelength conversion layer may further include a second type of particles converting a fraction of the light having a wavelength in the first wavelength band into light having a wavelength in a third wavelength band, in which the third wavelength band may be a longer wavelength region than the second wavelength band.

The side light extractor may include a first side light extractor disposed on a side of the light emitting source and a second side light extractor disposed at the other side of the light emitting source, in which a difference between a maximum height of the first side light extractor from the substrate and a maximum height of the second side light extractor from the substrate may be about 10%, and specifically, may be 10% or less.

The side light extractor may have a higher transmittance than the reflector.

An inclined region of the side light extractor may start at a height lower than 1/5 of the thickness of the light emitting source from the upper surface of the substrate.

A starting point of the side light extractor from the upper surface of the substrate may be lower than an active region of the light emitting source.

The side light extractor may have a light transmittance of 70% or more.

The reflector may include a linear region adjoining the wavelength conversion layer, in which the linear region may include a height corresponding to a thickness of the wavelength conversion layer.

The reflector may include a first reflector formed at a side of the light emitting source and a second reflector formed at the other side of the light emitting source, in which the first reflector and the second reflector may include different widths with reference to an imaginary horizontal line from the upper surface of the substrate.

The reflector may include a first reflector and a second reflector formed at both sides of the light emitting source, in which the first reflector and the second reflector may include different widths with reference to an imaginary horizontal line from the upper surface of the substrate.

According to one or more embodiments of the present disclosure, a light emitting device includes: a light emitting source including a light emitting semiconductor device; a reflector disposed on a side region of the light emitting source while at least partially adjoining the side region of the light emitting source; a front-light extractor disposed on the light emitting source and the reflector; a wavelength conversion layer disposed in at least a region on a light path of the light emitting source; a side light extractor disposed between the light emitting source and the reflector; and a substrate on which the light emitting source, the reflector, and the front-light extractor are disposed. When at least one side region of the light emitting source include a length d1 in a lateral direction and a side region of the wavelength conversion layer include a length d2 in the same lateral direction, the length d1 may be less than or equal to d2.

The length d2 of the wavelength conversion layer may satisfy a relationship $d1 \times 1.1 < d2 < d1 \times 1.7$.

The wavelength conversion layer may be a film or sheet type and a thickness deviation of the wavelength conversion layer on an upper surface of the light emitting source may be less than 10%.

A ratio of an area of the wavelength conversion layer to an area of the light emitting source may be 150% or less.

Light emitted from the light emitting source may have a first wavelength band and the wavelength conversion layer may include a first type of particles converting a fraction of the light having a wavelength in the first wavelength band into light having a wavelength in a second wavelength band, in which the first wavelength band may be a shorter wavelength region than the second wavelength band.

The wavelength conversion layer may further include a second type of particles converting a fraction of the light having a wavelength in the first wavelength band into light having a wavelength in a third wavelength band, in which the third wavelength band may be a longer wavelength region than the second wavelength band.

The side light extractor may have a higher transmittance than the reflector.

The side light extractor may include a first side light extractor disposed on a side of the light emitting source and a second side light extractor disposed at the other side of the light emitting source, in which a difference between a maximum height of the first side light extractor from the substrate and a maximum height of the second side light extractor from the substrate may be about 10%, and specifically, may be 10% or less.

The side light extractor may include a maximum thickness not exceeding a thickness of the light emitting source.

An inclined region of the side light extractor may start at a height lower than 1/5 of the thickness of the light emitting source from the upper surface of the substrate.

A starting point of the side light extractor from the upper surface of the substrate may be lower than an active region of the light emitting source.

The reflector may include a linear region adjoining the wavelength conversion layer, in which the linear region may include a height corresponding to a thickness of the wavelength conversion layer.

The reflector may include a first reflector formed at a side of the light emitting source and a second reflector formed at the other side of the light emitting source, in which the first reflector and the second reflector may include different widths with reference to an imaginary horizontal line from the upper surface of the substrate.

The reflector may include a first reflector and a second reflector formed at both sides of the light emitting source, in which the first reflector and the second reflector may include different widths with reference to an imaginary horizontal line from the upper surface of the substrate.

According to one or more embodiments of the present disclosure, a light emitting device includes: a light emitting source including a plurality of light emitting semiconductor devices; a reflector disposed on a side region of the light emitting source while at least partially adjoining the side region of the light emitting source; a front-light extractor disposed on the light emitting source and the reflector; a wavelength conversion layer disposed in at least a region on a light path of the light emitting source; a side light extractor disposed between the light emitting source and the reflector; and a substrate on which the light emitting source, the reflector, and the front-light extractor are disposed. A length of the wavelength conversion layer may be greater than the sum of a length of a side region of the plurality of light emitting semiconductor devices and a distance between the light emitting semiconductor devices.

The distance between the light emitting semiconductor devices may be less than the length of the one side region of the semiconductor devices.

The wavelength conversion layer may be a film or sheet type and a thickness deviation of the wavelength conversion layer on an upper surface of the light emitting source may be less than 10%.

A ratio of an area of the wavelength conversion layer to an area of the light emitting source may be 150% or less.

Light emitted from the light emitting source may have a first wavelength band and the wavelength conversion layer may include a fist type of particles converting a fraction of the light having a wavelength in the first wavelength band into light having a wavelength in a second wavelength band, in which the first wavelength band may be a shorter wavelength region than the second wavelength band.

The wavelength conversion layer may further include a second type of particles converting a fraction of the light having a wavelength in the first wavelength band into light having a wavelength in a third wavelength band, in which the third wavelength band may be a longer wavelength region than the second wavelength band.

The side light extractor may have a higher transmittance than the reflector.

The side light extractor may include a first side light extractor disposed on a side of the light emitting source and a second side light extractor disposed at the other side of the light emitting source, in which a difference between a maximum height of the first side light extractor from the substrate and a maximum height of the second side light extractor from the substrate may be about 10%, and specifically, may be 10% or less.

The side light extractor may include a maximum thickness not exceeding a thickness of the light emitting source.

An inclined region of the side light extractor may start at a height lower than 1/5 of the thickness of the light emitting source from the upper surface of the substrate.

A starting point of the side light extractor from the upper surface of the substrate may be lower than an active region of the light emitting source.

The side light extractor may have a light transmittance of 70% or more.

The reflector may include a linear region adjoining the wavelength conversion layer, in which the linear region may include a height corresponding to a thickness of the wavelength conversion layer.

The reflector may include a first reflector formed at a side of the light emitting source and a second reflector formed at the other side of the light emitting source, in which the first reflector and the second reflector may include different widths with reference to an imaginary horizontal line from the upper surface of the substrate.

[Advantageous Effects]

According to one embodiment of the present invention, the light emitting device can maximize light extraction efficiency by minimize light loss.

According to one embodiment of the present invention, the light emitting device can delay moisture penetration while improving reliability through increase in length of a moisture penetration path.

According to one embodiment of the present invention, the light emitting device can improve structural stability by reducing stress caused by external pressure while minimizing concentration of stress on corners thereof.

According to one embodiment of the present invention, the light emitting device can reduce yellowing and discoloration while improving reliability through improvement in light stability.

According to one embodiment of the present invention, the light emitting device can improve light extraction efficiency and light quantity through reduction in side emitting light loss.

According to one embodiment of the present invention, the light emitting device can improve color purity through reduction in chromatic aberration.

[Brief Description of Drawings]

FIG. 1 is a schematic perspective view of a light emitting device 20 according to one embodiment of the present invention.

FIG. 2 is a cross-sectional view of a light emitting device 20 that includes a reflector 230 including a first reflective surface 230a including a curved shape and a side light extractor 260 according to one embodiment of the present invention.

FIG. 3 is a cross-sectional view of a light emitting device 20 that includes a reflector 230 including a first reflective surface 230a including a concave shape and a side light extractor 260 according to one embodiment of the present invention.

FIG. 4 is a cross-sectional view of a light emitting device 20 including a plurality of light emitting semiconductor devices 220a according to one embodiment of the present invention.

FIG. 5 is a cross-sectional view of a light emitting device 20 including a plurality of light emitting semiconductor devices 220a and a plurality of wavelength conversion members 270a according to one embodiment of the present disclosure.

FIG. 6 is a view of a front-light extractor 240 including a neck 240b including an inclined region according to one embodiment of the present invention.

FIG. 7 is a view of a front-light extractor 240 that includes a neck 240b including a concave-shaped region, according to one embodiment of the present invention.

FIG. 8 is a view of a front-light extractor 240 that includes a neck 240b including a curved region according to one embodiment of the present invention.

FIG. 9 is a cross-sectional view of a light emitting device 20 that includes a reflector 230 including a second reflective surface 230b including a concave shape and a side light extractor 260 according to one embodiment of the present invention.

FIG. 10 is a cross-sectional view of a light emitting device 20 that includes a reflector 230 including a second reflective surface 230b including a curved shape and a side light extractor 260 according to one embodiment of the present invention.

FIG. 11 is a view of the side light extractor 260 and a light transmission layer 220c of the light emitting device 20 according to the embodiment of the present invention.

FIG. 12 is a view of the reflector 230 of the light emitting device 20 according to the embodiment of the present invention.

FIG. 13 is a view of a light emitting source 220 of the light emitting device 20 according to the embodiment of the present invention.

[Detailed Description]

The present disclosure may be variously modified and realized in many different forms, and thus specific embodiments will be exemplified in the drawings and described in detail herein below. However, in the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "includes," "including," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

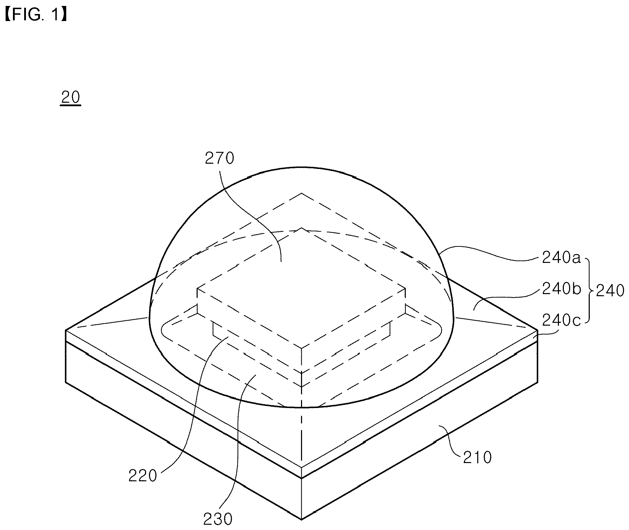

FIG. 1 is a schematic perspective view of a light emitting device 20 according to one embodiment of the present invention.

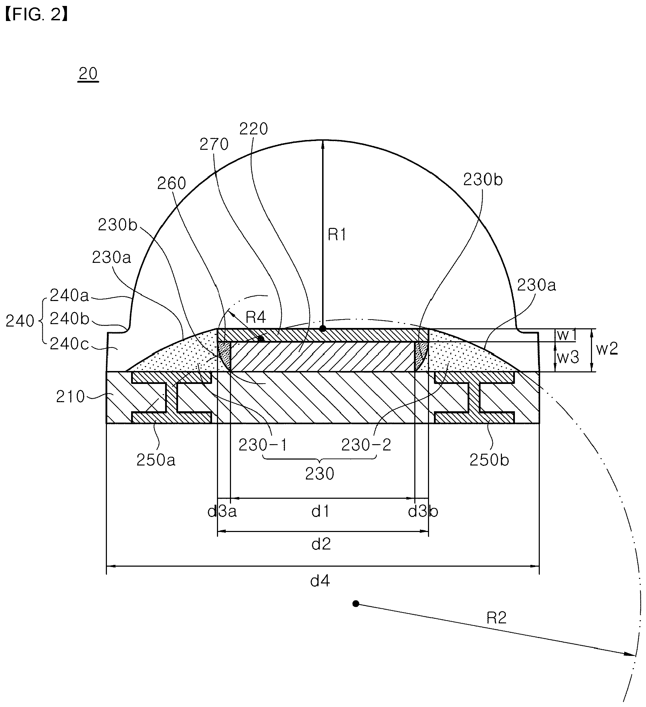

Referring to FIG. 1 and FIG. 2, the light emitting device 20 includes a substrate 210, a light emitting source 220, a reflector 230, a front-light extractor 240, a side light extractor 260, and a wavelength conversion layer 270.

The light emitting source 220, the reflector 230, the front-light extractor 240, the side light extractor 260, and the wavelength conversion layer 270 may be mounted on an upper surface of the substrate 210.

The substrate 210 may be formed to have high thermal conductivity and high reflection efficiency (using a material having these properties). For example, the substrate 210 may be formed of aluminum nitride (AlN) ceramics or $Al_2O_3$ ceramics, plastics including polymers, and the like. The substrate 210 may be formed of acrylonitrile butadiene styrene (ABS), liquid crystalline polymers (LCPs), polyamide (PA), polyphenylene sulfide (IPS), thermoplastic elastomers (TPEs), or a metal. By way of example, the substrate 210 may have a thermal conductivity of about 170 W/mk. In addition, materials, such as Cu, Ag, Au, Al, and the like, may be added to (e.g., coated or deposited on) the substrate 210 to improve reflection efficiency and the like. However, it should be understood that the substrate 210 is not limited thereto and may be formed of various materials, such as GaAs, GaN, Si, Al, Cu, and/or sapphire. In addition, at least a region of the substrate 210 may have a transmittance of 50% or more to increase a light emission region. The substrate 210 may also have a reflectivity of 50% or more in a region thereof and may allow adjustment of beam angle. Further, the substrate 210 may be formed of a material such as PET or PVB, and may have bending properties.

The light emitting source 220 may include at least one light emitting semiconductor device. The light emitting semiconductor device may generate and emit light through an active layer activated upon application of electric current. The light emitting semiconductor device may include an LED chip. The LED chip may be, for example, an LED chip that generates light in a particular region (e.g., ultraviolet light, blue light, green light, yellow light, red light, infrared light). The light emitting source 220 may have a thickness w3 with respect to the upper surface of the substrate 210. The light emitting source 220 may include a substrate layer, a buffer layer, an undoped layer, a first conductivity type semiconductor layer, a strain relief layer, a lower super-lattice layer, an upper super-lattice layer, an active region, an electron blocking layer, a second conductivity type semiconductor layer, and a transparent electrode layer.

The light emitting source 220 may include a plurality of light emitting semiconductor devices. The light emitting source 220 may include two, three, four or more light emitting semiconductor devices, each of which may have a peak wavelength with a difference of less than 10 nm therebetween, thereby realizing high color purity. In addition, the plurality of light emitting semiconductor devices may have different peak wavelengths with a difference of 10 nm or more therebetween, thereby realizing various colors.

The reflector 230 may surround at least a region of the light emitting source 220. The reflector 230 reflects incident light to the outside of the light emitting device 20. Due to reflection inside the light emitting device 20, at least a fraction of light emitted from the light emitting source 220 may reach the surface of the reflector 230, which may reflect the light towards the front-light extractor 240 to improve light extraction efficiency of the light emitting device 20 and may adjust the beam angle of light emitted from the light emitting device 20. Further, the reflector 230 may reflect lateral light emitted from the light emitting source 220 to the front-light extractor 240. Accordingly, light emitted from the light emitting device 20 can improve uniformity of light depending on the beam angle. The reflector 230 may have a light reflectivity of 70% or more for light emitted from the light emitting source 220. For example, the reflector 230 may have a light reflectivity of 80% or more for light in the visible spectrum. In addition, the reflector 230 may have a light reflectivity of 90% or more for light in the blue wavelength band, without being limited thereto. The reflector 230 may be composed of a material having light reflectivity for light emitted from the light emitting source 220. The reflector 230 may include a polymer organic compound, such as a silicone resin, an epoxy or fluoropolymer resin, and the like, and may further include various additives, such as $TiO_2$, $Ba_2Ti_9O_{20}$, $BaSO_4$, $SiO_2$, $CaCOs$, $ZnO$, $CaCOs$, and the like to improve light reflectivity. In addition, the reflector 230 may also cover at least one side region of the light emitting source 220 to increase the length of a moisture penetration path, thereby delaying moisture penetration while improving reliability. Further, the reflector 230 may cover at least one surface of the substrate 210 to prevent discoloration of the one surface of the substrate by light, thereby improving light safety while reducing yellowing and discoloration.

The front-light extractor 240 may cover at least a region of the light emitting source 220 and/or the reflector 230. The front-light extractor 240 may be an optical lens that extracts light emitted from the light emitting source 220 and light reflected from the reflector 230 towards a front or side region of the light emitting device 20 while adjusting the beam angle. The beam angle of the light emitting device 20 may range, for example, from 15 degrees to 180 degrees with respect to the center of the front-light extractor 240, without being limited thereto. The front-light extractor 240 may be formed of a variety of materials, such as phenyl silicone, methyl silicone, epoxy, fused silica, borosilicate, soda-lime glass, aluminosilicate, fluoropolymer, polyphthalamide (PPA), polybutylene terephthalate (PBT), polycarbonate (PC), and the like.

The front-light extractor 240 includes a body 140a. The body 140a of the front-light extractor 240 may include a region of a curved shape (hereinafter, first curved shape), which at least partially or completely covers the light emitting source 220 and the reflector 230. By way of example, the first curved shape may be a dome, hemispherical, or elliptical shape, without being limited thereto, may act as a lens that adjusts the beam angle by adjusting, focusing or diffusing light emitted from the light emitting source 220, and may minimize light loss to increase light extraction efficiency.

The front-light extractor 240 may further include at least one of a neck 140b or a spacer 140c. The distinction between the body 140a, the neck 140b, and the spacer 140c on the front-light extractor 240 is for convenience of description only and, depending on embodiments, the body 140a, neck 140b, and spacer 140c may be integrally formed with each other, may include the same material, and may have reduced openings to reduce the moisture penetration path and delay moisture penetration while improving reliability. On the other hand, at least one of the neck 140b and the spacer 140c may be omitted depending on the size or shape of the body 140a. At least one surface of the body 140a, the neck 140b, and the spacer 140c of the front-light extractor 240 may have a curvature to reduce stress caused by external pressure while improving structural stability.

FIG. 2 is a sectional view of the light emitting device 20 according to one embodiment of the present invention. FIG. 2 may be understood as a more specified example of the light emitting device 20 shown in FIG. 1. Accordingly, repeated description of the configuration mentioned above in FIG. 1 will be omitted and the description with reference to FIG. 1 may be referred to in order to understand the example shown in FIG. 2, even if not otherwise indicated.

Referring to FIG. 2, the substrate 210 may include at least one electrode 250 for applying electric current to the light emitting source 220. The electrodes 250 may include a first electrode 250a and a second electrode 250b. The first electrode 250a and the second electrode 250b are each electrically connected to the light emitting source 220. The light emitting source 220 may include electrodes corresponding to the first electrode 250a and the second electrode 250b. The substrate 210 may include an upper electrode electrically connected to the electrodes of the light emitting source 220, a lower electrode on a lower surface thereof, and a through-electrode electrically connecting the upper electrode to the lower electrode. The light emitting source 220 may be electrically connected to the electrode 250 in various ways including wiring, bonding, soldering, and the like. The electrode 250 may be connected to an external power source to supply electric current to the light emitting source 220. The electrode 250 may be formed of materials with low electrical resistance to increase driving efficiency for smooth current supply and may include at least one of iron, copper, tin, gold, silver, aluminum, metal compounds, metal oxides, graphite, graphene, or anisotropic conductive materials.

In addition, the reflector 220 may be disposed in a region of the electrode 250. The reflector 220 may increase the moisture penetration path to the electrode 250 to prevent the electrode 250 from being oxidized by moisture, thereby improving reliability. In addition, the reflector 220 can prevent discoloration of the a region of the electrode, thereby reducing yellowing and discoloration through improvement in light stability.

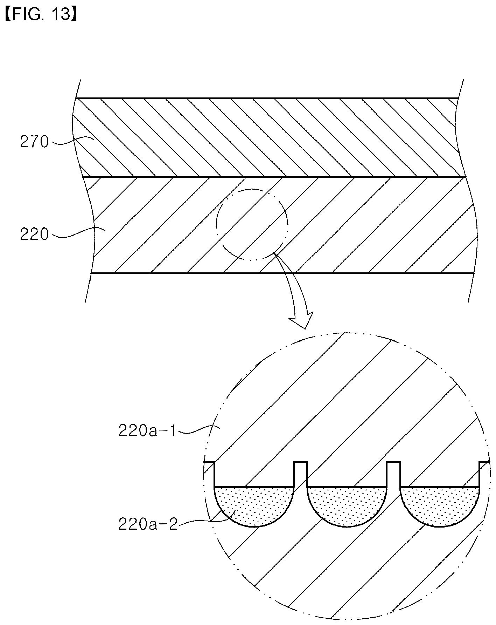

Alternatively, the substrate 10 may include a modified region on at least part of the upper surface thereof. The modified region serves to prevent light from being absorbed into the substrate 110 while (re)reflecting light to the outside, and may be formed of a highly reflective material. For example, the modified region may be formed of a metal, such as Ag, Cu, Au, ENEPIG, ENIG, Al, and the like, or a light dispersing material, such as $TiO_2$, $SiN$, $BaSO_4$, $Al_2O_3$, and the like. The light emitting semiconductor device of the light emitting source 220 may be disposed on one or more sides of the modified region and may improve light extraction efficiency through increase in reflectivity of the substrate. The modified region on the upper surface of the substrate 210 of FIG. 2 may be formed, for example, in the same structure as a roughness structure 220a, as shown in FIG. 13, without being limited thereto.

The reflector 230 may at least partially adjoin a side region of the light emitting source 220. The reflector 230 may form a wall/hill surrounding the side region of the light emitting source 220. By way of example, the wall/hill formed by the reflector 230 may be partially spaced apart from the side region of the light emitting source 220 while partially adjoining the side region thereof. A horizontal cross-sectional area of the wall formed by the reflector 230 may gradually decrease with increasing vertical distance from the upper surface of the substrate 210. At least a region of the wall/hill formed by the reflector 230 may include at least one inclined region. Each inclined region may include at least one of a linear region and/or a curved region. One of the inclined regions may have an ascending slope or curved shape towards the center of the light emitting device 20/body 240a and the reflector 230 may have a radius of curvature R2 formed from the upper surface of the substrate 210 towards the center of the light emitting device 20. More preferably, the reflector 230 has a thickness gradually increasing towards the center thereof and the thickness of the reflector 230 can be secured to increase reflectivity, thereby improving light extraction efficiency.

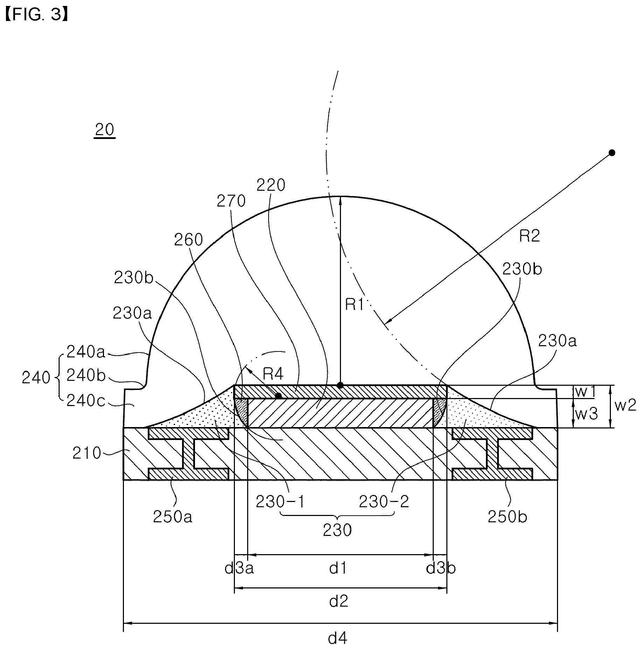

On the other hand, the reflector 230 of the light emitting device 20 is not limited to the shape shown in FIG. 2. For example, the reflector 230 may include an inclined or concave shape that descends with increasing distance from the center thereof, as shown in FIG. 3. More preferably, the reflector 230 has a thickness gradually decreasing with increasing distance from the center thereof. With the reflector 230 having such a descending slope, the light emitting device can achieve the effect of narrowing the beam angle.

The body 240a of the front-light extractor 240 may include a region of a first convex shape having a radius of curvature R1. The radius of curvature R1 of the body 240a may be determined in consideration of a target light beam angle or the like. By way of example, a distance from the upper surface of the light emitting source 220 to the center of the body 240a of the front-light extractor 240 may correspond to the radius of curvature R1. More specifically, the distance from the upper surface of the light emitting source 220 to the center of the body 240a of the front-light extractor 240 may be substantially equal to the radius of curvature R1. More preferably, the radius of curvature R1 is a distance from the highest point in a cross-section of the front-light extractor 240 to the upper surface of the light emitting source 220. In addition, the length of the light transmission path within the body 240a may correspond to/be substantially the same as the radius of curvature R1. When the length of the light transmission path is the same as the radius of curvature R1, light extraction efficiency of the light emitting device can be improved, thereby improving light output.

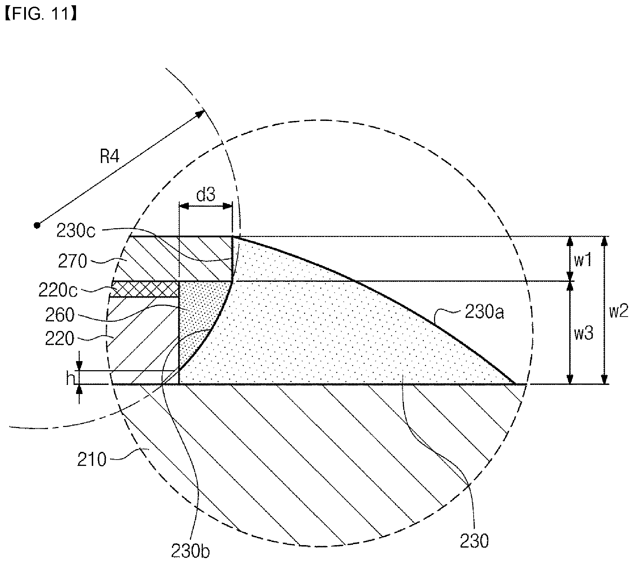

The wavelength conversion layer 270 may be disposed on at least one surface of a light exit path of light emitted from the light emitting source 220. The wavelength conversion layer 270 may be disposed to cover at least one surface of the light emitting source 220. The wavelength conversion layer 270 may be disposed to directly contact the light emitting source 220 or may be coupled to the light emitting source 220 through a coupling layer (e.g., 220c in FIG. 11) that is further disposed between the wavelength conversion layer 270 and the light emitting source 220.

The wavelength conversion layer 270 may include at least one type of particles for converting light having a wavelength in a first wavelength band, which is emitted from the light emitting source 220. The particles may include at least one of a first type of particles for converting a fraction of light having a wavelength in the first wavelength band into light having a wavelength in a second wavelength band or a second type of particles for converting a fraction of light having a wavelength in the first wavelength band into light having a wavelength in a third wavelength band. The first wavelength band may be a shorter wavelength region than the second wavelength band and the third wavelength band may be a longer wavelength region than the second wavelength band. Alternatively, the first wavelength band may be a shorter wavelength region than the second wavelength band and the third wavelength band may be a longer wavelength region than the second wavelength band. For example, the first wavelength band may be a blue wavelength band, the second wavelength band may be a yellow or green wavelength band, and the third wavelength band may be a red wavelength band.

The particles may be phosphor particles, quantum dots, organic dyes, or nonlinear optical converters. For example, the first type of particles are wavelength-shifting particles that emit light having a peak wavelength in the green or yellow wavelength band and may include at least one of quantum dots, LuAG series, YAG series, beta-SiAlON series, nitride series, silicate series, halophosphide series, or oxynitride series, without being limited thereto. The second type of particles may include red wavelength-shifting particles that emit light having a peak wavelength in the red wavelength band, and may include at least one of nitride series, silicate series, sulfide series, or fluoride series, such as quantum dots, CASN, CASON, and SCASN.

The wavelength conversion layer 270 may be a film or sheet type, such as PIS (phosphor in silicon), PIG (phosphor in glass), or PIC (phosphor in ceramic), may have a thickness deviation of less than 10% on the upper surface of the light emitting source 220, and may keep the light path constant to reduce chromatic aberration, thereby realizing a light emitting device with high color purity. The wavelength conversion layer 270 may include not only a silicone resin, such as methyl silicone and phenyl silicone, but also organic materials, such as a fluoropolymer, an epoxy resin, polyphthalamide (PPA), polybutylene terephthalate (PBT), and polycarbonate (PC), glass, such as borosilicate, aluminosilicate, and soda-lime glass, and inorganic materials, such as fused quartz.

The wavelength conversion layer 270 may have a larger area than or the same area as one surface of the light emitting source 220. The wavelength conversion layer 270 may be formed to have a larger area than or the same area as the upper surface of the light emitting source 220. By forming the wavelength conversion layer 270 to have a larger area than or the same area as than the upper surface of the light emitting source 220, the path for light emitted from the light emitting source 220 and passing through the wavelength conversion layer 270 can be increased, thereby improving wavelength conversion efficiency of light emitted from the light emitting source 220. When the wavelength conversion layer 270 is formed to have a larger area than the upper surface of the light emitting source 220, the area of the wavelength conversion layer 270 may be 150% or less of the area of the upper surface of the light emitting source 220. If the area of the wavelength conversion layer 270 is larger than 150% of the area of the upper surface of the light emitting source, the amount of particles in the wavelength conversion layer 270 can increase above the quantity of light emitted from the light emitting source 220, which activates the particles, causing reduction in wavelength conversion efficiency. As a result, color uniformity of light according to the angle of incidence of final light realized by combination of light emitted through the light emitting source 220 and light emitted through the wavelength conversion layer 270 can be reduced.

The side region of the light emitting source 220 may have a length d1 in the lateral direction and the side region of the wavelength conversion layer 270 may have a length d2 in the same lateral direction, in which d1 may be less than or equal to d2. More preferably, a ratio of the length d2 to the length d1 may range from 100% to 150%. When the length d2 is greater than the length d1, a light emission area of the light emitting device can be enlarged, thereby improving light extraction efficiency. Further, in a plan view, the light emitting source 220 may have a rectangular or polygonal shape with one side having a length d1 and the wavelength conversion layer 270 may have a rectangular or polygonal shape with one side having a length d2, or a circular or elliptical shape having a diameter d2.

Furthermore, the lengths d1 and d2 may be smaller than the radius of curvature R1 of the front-light extractor 240, whereby the light emitting device can have an enlarged light exit area relative to the light emission area, thereby improving light extraction efficiency.

The length d1, d2 may be smaller than the radius of curvature R2 of the reflector 230, whereby the light emitting device can secure a lateral thickness and reflectivity of the reflector, thereby increasing the quantity of light through improvement in lateral light extraction efficiency.

The sum of the thicknesses of the light emitting source 220 and the wavelength conversion layer 270 from the upper surface of the substrate 210 may be w2. The wavelength conversion layer 270 may have a predetermined thickness w1. A thickness w3 of the light emitting source 220 is less than or equal to a value of w2-w1 or less with respect to the upper surface of the substrate 210. The thickness w3 of the light emitting source 220 may be greater than the thickness w1 of the wavelength conversion layer 270. By forming the light emitting source 220 to have a thickness w3 greater than the thickness w1 of the wavelength conversion layer 270, the side light extractor 260, which will be described below, can be stably formed, thereby improving light extraction efficiency. In addition, the thickness w3 of the light emitting source 220 may be smaller than the maximum radius of curvature R4 of a curved shape of the side light extractor 260 described below to increase lateral light extraction efficiency by increasing the amount of photons transmitted to the wavelength conversion layer 270 through extraction of light emitted from the side region of the light emitting device and distortion of the direction of the lateral light to a certain direction.

Further, the thickness w1 of the wavelength conversion layer 270 may be uniform with a deviation of 10% or less with reference to an average thickness and deviation of color conversion efficiency according to the thickness w1 can be reduced, thereby securing high color purity of the light emitting device.

The reflector 230 may adjoin at least a region of the side regions of the light emitting source 220 and the wavelength conversion layer 270, whereby the beam angle of the light emitting device 20 can be adjusted.

The light emitting device 20 may further include a side light extractor 260 disposed between the side region of the light emitting source 220 and the reflector 230. The side light extractor 260 may be formed to surround at least a region of the side region of the light emitting source 220. The side light extractor 260 may adjoin at least a region of the side region of the light emitting source 220. This structure can increase the quantity of light by improving efficiency in extraction of light emitted from the side region of the light emitting source 220. Further, the side light extractor 260 may adjoin at least a region of a lower surface of the wavelength conversion layer 270. This structure allows light emitted from the side region of the light emitting source 220 to be incident on the wavelength conversion layer 270, thereby improving color purity of the light emitting device 20. Furthermore, the side light extractor 260 may adjoin at least a region of the side region of the wavelength conversion layer 270. This structure can improve efficiency in extraction of light emitted in a thickness direction of the wavelength conversion layer.

The side light extractor 260 may extract light emitted from at least one of a region of the light emitting source 220 having a thickness w3. The side light extractor 260 may extract light generated and emitted from the side region of the light emitting source 220 and may distort the direction of lateral light to a certain direction to increase the amount of photons transmitted to the wavelength conversion layer 270. That is, the side light extractor 260 can prevent light emitted from the side region of the light emitting source 220 from being emitted to the outside of the light emitting device without passing through the wavelength conversion layer 270. Accordingly, the side light extractor can improve not only wavelength conversion efficiency of light emitted from the light emitting source 220, but also color temperature uniformity of final light emitted from the light emitting device 20 according to the light emission direction of the final light. More preferably, the thickness w3 of the light emitting source 220 is smaller than the maximum radius of curvature R4 of the curved shape of the side light extractor 260 described below to improve efficiency in extraction of lateral light by increasing the amount of photons transmitted to the wavelength conversion layer 270 through extraction of light emitted from the side region of the light emitting device and distortion of the direction of the lateral light to a certain direction.

The side light extractor 260 may include a silicone resin, such as methyl silicone and phenyl silicone, but is not limited thereto. The side light extractor may also include an organic material, such as a fluoropolymer, an epoxy resin, polyphthalamide (PPA), polybutylene terephthalate (PBT), and polycarbonate (PC), and the like, which can act as a diffuser to disperse light. In addition, substances, such as silica and the like, may be added to act as the diffuser and provide have high color purity by improving chromatic aberration.

By way of example, in a cross-section of the light emitting device 20, each of the side light extractors 260 at both sides of the light emitting device 20 may adjoin a lower surface of the wavelength conversion layer 270 in a region corresponding to a length of (d2-d1)/2. In other words, one side region of the side light extractor 260 may have a length of (d2-d1)/2 in the same direction as the direction in which the light emitting source 220 and the wavelength conversion layer 270 have lengths d1 and d2 in the lateral direction of the side region, respectively, and lateral light may pass through the wavelength conversion layer 270 to reduce chromatic aberration while improving color purity. By way of example, the side light extractor 260 may include a region, the horizontal cross-sectional area of which gradually increases with increasing vertical distance from the upper surface of the substrate, thereby improving light extraction efficiency through increase in cross-sectional area of the light exit region. By way of example, the side light extractor 260 may have a maximum thickness not exceeding w2-w1 and the path of lateral light emitted from the light emitting source 220 may be allowed to pass through the wavelength conversion layer 270, thereby reducing chromatic aberration depending on the beam angle. By way of example, the side light extractor 260 may have a maximum thickness smaller than or equal to the thickness w3 of the light emitting source 220 and can improve light extraction efficiency by reflecting the lateral light towards an upper surface thereof. By way of example, the side light extractor 260 may include a linear region on at least a region of one surface thereof, in which the linear region may be formed in a region adjoining the light emitting source 220 or the wavelength conversion layer 270, thereby improving light extraction efficiency by increasing a contact area of a bonding region. By way of example, the side light extractor 260 may include a curved region in at least a region of one surface thereof to adjust a light exit angle while improving light extraction efficiency. By way of example, the side light extractor 260 may include an inclined region on at least a region of one surface thereof to adjust the light exit angle through the inclined region. By way of example, the side light extractor 260 may include linear and curved regions on at least a region of one surface thereof to adjust the light exit angle through the inclined and linear regions. By way of example, the side light extractor 260 may have a higher light transmittance than the reflector 230 and may adjust the beam angle by refracting light into a region having high transmittance. Specifically, the side light extractor 260 may have a light transmittance of 70% or more. By way of example, the side light extractor 260 may have a lower reflectivity than the reflector 230 and may adjust the beam angle through adjustment in difference of reflectivity therebetween. On the other hand, the reflector 230 of the light emitting device 20 is not limited to the shape shown in FIG. 2. For example, the reflector 230 may include a downwardly curved surface, as shown in FIG. 3, to narrow the beam angle of emitted light through a concave region thereof.

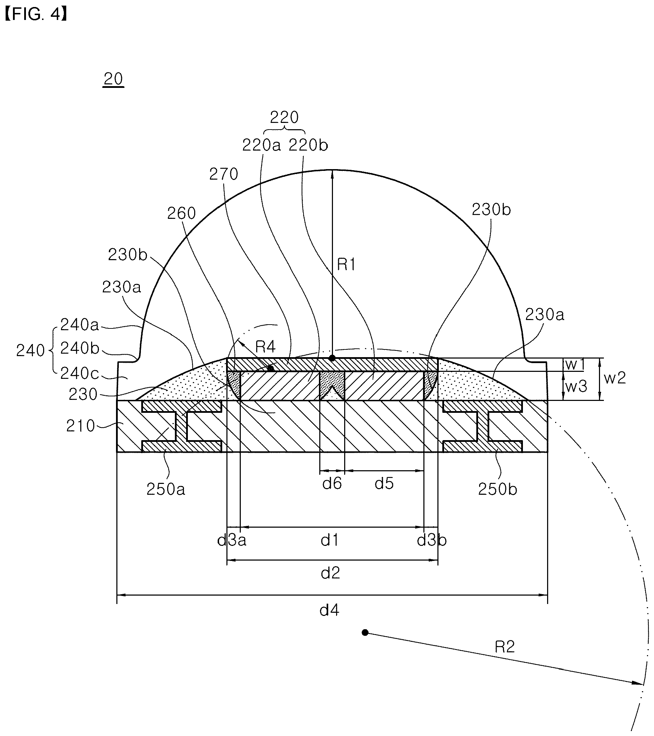

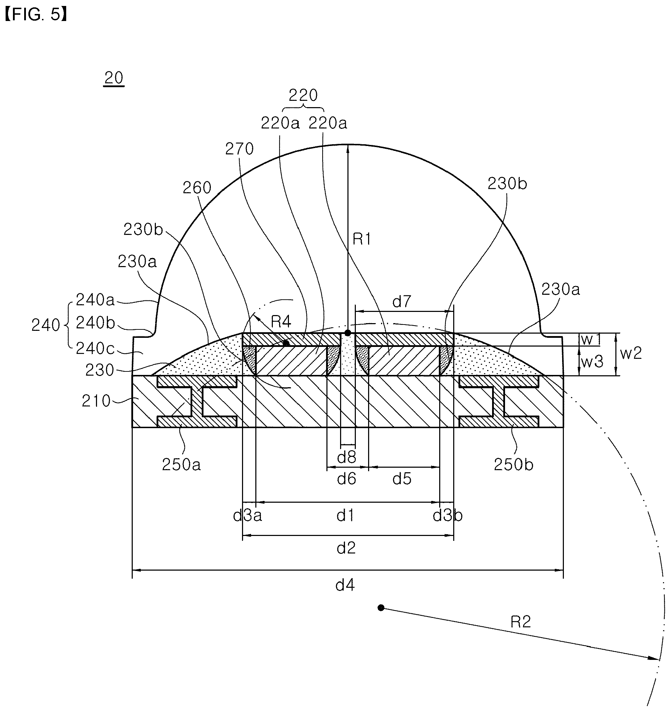

In addition, although the light emitting source 220 of the light emitting device 20 may include a single light emitting semiconductor device in FIG. 2 and FIG. 3, it should be understood that the present invention is not limited thereto. For example, referring to FIG. 4 and FIG. 5, the light emitting source 220 may include a plurality of light emitting semiconductor devices 220a.

Referring to FIG. 4, for the light emitting source 220 including more than one light emitting semiconductor devices 220a, d1 may correspond to the sum of lengths d5 of side regions of the light emitting semiconductor devices 220a and a distance d6 between the light emitting semiconductor devices 220a. For example, when the light emitting source 220 includes a plurality of light emitting semiconductor devices 220a, d1 may be greater than or equal to the sum of the lengths d5 of the light emitting semiconductor devices 220a and the distance d6 between the light emitting semiconductor devices 220a, and the distance between the light emitting semiconductor devices may be maintained to allow the light emitting semiconductors to act as a single light source, thereby improving light extraction efficiency of the front-light extractor. The length d2 may correspond to the length of the wavelength conversion layer 270 and may be set to be greater than the length d1 to improve light extraction efficiency through enlargement of a light emission surface. The distance d6 between the light emitting semiconductor devices 220a may be smaller than the length d5 of the semiconductor device 220a and a region therebetween may be filled with a material including the same material as the reflector 230 or the side light extractor 260 to delay moisture penetration while improving reliability through increase in length of the moisture penetration path.

Referring to FIG. 5, the light emitting source 220 may be provided with a plurality of light emitting semiconductor devices 220a and a plurality of wavelength conversion members 270a, in which the length d2 may be greater than or equal to the sum of lengths d7 of the plurality of wavelength conversion members 270a, and can improve light extraction efficiency through enlargement of the light emission surface. The length d2 may correspond to the sum of the lengths d7 of the wavelength conversion members 270a and the distance d8 between the wavelength conversion members 270a. Further, the length d2 of each of the plurality of wavelength conversion members 270a may be longer than the length of one of the plurality of light emitting semiconductor devices 220a, thereby improving light extraction efficiency through enlargement of the light emission surface. Furthermore, the sum of the lengths d7 of the wavelength conversion members 270a may be smaller than the radius of curvature R1 of the front-light extractor 240, thereby improving light extraction efficiency by securing a sufficient radius of the front-light extractor 240 relative to the light emission surface.

Hereinafter, for convenience of description, the light emitting device 20 and/or at least one of light emitting devices 20 will be referred to as the light emitting device x0. Likewise, the substrate 210, the light emitting source 220, the reflector 230, the front-light extractor 240, and the electrode 250 of the light emitting device x0 may be briefly denoted as the substrate x10, the light emitting source x20, the reflector x30, the front-light extractor x40, the electrode x50, respectively, in which x may mean 2.

In the reflector x30 applicable to the light emitting device x0, at least a region of the wall/hill formed by the reflector x30 may include a curved inclined region that ascends toward the center of the light emitting device x0/body x40a or descends toward the outside, in which the curved inclined region may be included in a first reflective surface x30a of the reflector x30. Hereinafter, the radius of curvature of the curved surface with respect to the inclined region of the first reflective surface x30a will be referred to as R2.

For example, referring to FIG. 2, the reflector 230 may include a first reflective surface 230a that includes a second curved region including a curved shape.

Although the second curved shape is shown as being formed over the entirety of the first reflective surface x30a for convenience, it should be understood that the present invention is not limited thereto and the second curved shape may be formed over a region of the first reflective surface x30a. Although the second curved shape is shown as having a single radius of curvature R2, it should be understood that the present invention is not limited thereto. For example, the second curved shape may include one or more radii of curvature located within a certain range from R2. By way of example, the second curved shape may be defined, for example, by the slope of the first reflective surface x30a. For example, the first reflective surface x30a may include a region where the slope gradually decreases (or saturates) with decreasing distance from the light emitting source x20 in a lateral direction or gradually increases with increasing distance from the light emitting source x20 in the lateral direction, or may include a curved surface ascending toward the center of the light emitting source 220 to adjust the beam angle through the curved shape.

According to one embodiment, the radius of curvature R2 may be different from the radius of curvature R1 of the body x40a of the front-light extractor x40.

In order to improve light extraction efficiency in the direction of the beam angle, the radius of curvature R1 in the light emitting device 10 may be optimized according to the length d1 of the wavelength conversion layer 270. Lens radius optimization efficiency y according to the ratio of the radius of curvature R1 to the length d2 (k = R1/d2) may be expressed as a quadratic function of Equation 1.

[Equation 1]

$$y = -0.4447k^2 + 1.0116k + 0.4534$$

For example, when defining an efficiency y= 102% for k=1, the k value may be determined such that the lens radius optimization efficiency y is greater than or equal to 80% (i.e., greater than or equal to 0.8). For example, if R1 is 1.7 mm for d2 = 1.6 mm, the lens radius optimization efficiency y is 100%.R1 may range from about 0.7 mm to less than 2.9 mm.

In the above examples, the volume of the reflector x30 may be determined by way of example according to the sizes of the wavelength conversion layer 270, the light emitting source x20, and the light emitting device x0. By way of example, when the substrate x10 of the light emitting device x0 has a size of 3.5 mm x 3.5 mm and the light emitting semiconductor device of the light emitting source x20 has a size of about 1,550 $\mu$m x 1,550 $\mu$m x 150 $\mu$m (i.e., d1= 1,550 $\mu$m, w2-w1= 150 $\mu$m), the reflector x30 may have a volume of about 0.50 $\mu$l to about 1.5 $\mu$l, preferably about 1 $\mu$l. More preferably, the volumes of the wavelength conversion layer 270 and the reflector x30 may be larger than the volume of the light emitting source 220, and the length of the moisture penetration path is increased to delay moisture permeation while improving reliability.

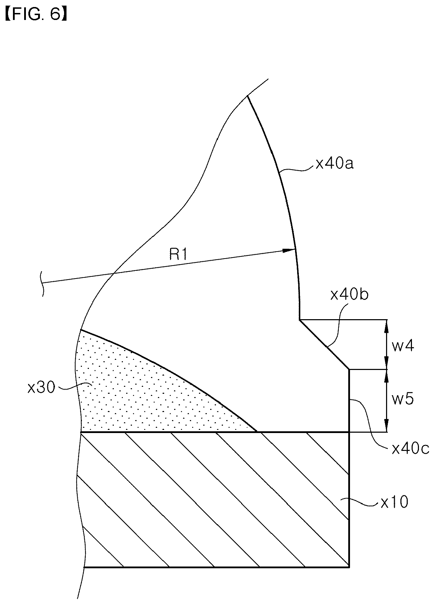

Referring to FIG. 6 to FIG. 8, one example of the front-light extractor x40 applicable to a light emitting device x0 will be described.

The radius of curvature R1 of the body x40a of the front-light extractor x40 may be determined in consideration of at least one of a target beam angle of light or (w1+w3). For the light emitting device 20, (w1+w3) may refer to a distance from the upper surface of the substrate 210 to an upper surface of the wavelength conversion layer 270.

For example, it may be desirable that a (constant) radius of curvature R1 be maintained from (w1+w3) in order to extract light in the direction of the target beam angle of light. In other words, it is desirable that the distance from (w1+w3) to the apex of the front-light extractor x40 be formed substantially equal to the radius of curvature R1. More preferably, a difference between the distance to the apex of the front-light extractor 240 and the radius of curvature R1 is less than 10%.

In order to solve this problem, according to one embodiment of the invention, the front-light extractor x40 may further include a spacer x40c and/or a neck x40b. The spacer x40c may extend from a lower distal end of the body x40a in the vertical direction and may adjoin the upper surface of the substrate x10. The neck x40b may be disposed between the spacer x40c and the body x40a to connect the spacer x40c to the body x40a. By way of example, the sum (w4+w5) of the thickness w4 of the neck x40b and the thickness w5 of the spacer x40c may be greater than or equal to the sum (w1 +w3) of the thickness w3 of the light emitting source 220 and the thickness w1 of the wavelength conversion layer 270, and a starting point of the curved surface of the body x40a may be flush with or higher than the light exit surface of light subjected to wavelength conversion to adjust the light path such that more light exits the upper surface than the side region, thereby improving light extraction efficiency. The height of the front-light extractor x40 from the upper surface of the substrate x10 may be the sum (w5 + w4 + R1) of the thickness w4 of the neck x40b, the thickness w5 of the spacer x40c and the radius of curvature R1 of the front-light extractor, and may be higher than or equal to w2 + R1 or w1 + w3 + R1, thereby improving light extraction efficiency through optimization of the light path.

For example, the radius of curvature R1 may satisfy a relationship: R1 ≥ 4 x M. M may be w2, or w1 + w3, or w5 + w4. In this way, when R1 is four times M, the light path of the front-light extractor 240 can be sufficiently secured such that the light emitting device 20 can have a beam angle of 140 degrees or less to increase illuminance.

The neck x40b may include an inclined region that narrows toward the center of the body x40a. For example, the neck x40b may have a horizontal circumference gradually decreasing with increasing distance from the upper surface of the substrate x10. A circumference of a first horizontal cross-section of the neck x40b in a region adjoining the body x40a may be less than a circumference of a second horizontal cross-section of the neck x40b in a region adjoining the spacer x40c, and as the neck x40b narrows toward the center of the body x40a, corner stress applied to the neck x40b can be gradually reduced, thereby reducing delamination or fracture at a corner thereof due to external impact.

The inclined region of the neck x40b may include at least one of a linear region or a curved region.

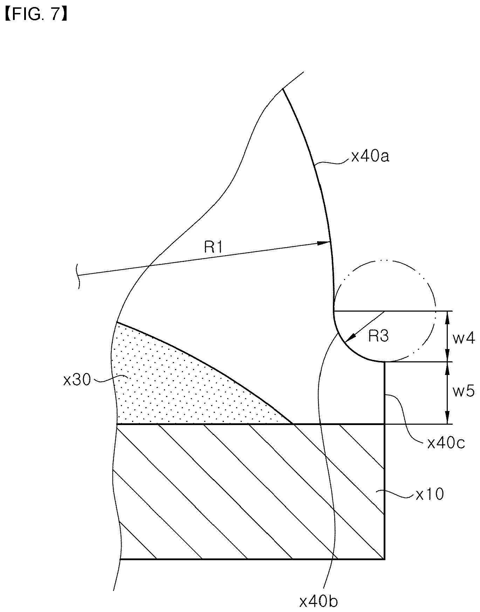

Referring to FIG. 7, the inclined region of the neck x40b may include a region of a concave shape. Although FIG. 7 illustrates that the concave shape is formed over the entire inclined region of the neck x40b, it should be understood that the present invention is not limited thereto and the concave shape may be formed over a region of the inclined region of the neck x40b. More preferably, the inclined region of the neck x40b is formed in a region of the corner thereof, thereby relieving corner stress to improve durability while reducing lens detachment or delamination between the spacer 240c and the substrate 210 due to sudden change in ambient temperature.

Although FIG. 7 illustrates that the concave shape of the inclined region of the neck x40b has a single radius of curvature R3, it should be understood that the present invention is not limited thereto. For example, the concave shape may include one or more radii of curvature within a certain range from R3. The radius of curvature R3 may be less than the radius of curvature R4. For example, the radii of curvature R3 and R4 may satisfy the relationship R4 ≥ R3. More specifically, when R4 ranges from about 0.1 mm to 1.5 mm, R3 may range from about 0.1 mm to 0.36 mm and the radius of curvature may be varied to increase light extraction efficiency by preventing reentrance of light.

By way of example, the inclined region of the neck x40b may be defined by a slope. For example, the light emitting source 120/body x40a may include a region where the slope gradually increases with decreasing distance from the center of the light emitting source 120/body x40a in the lateral direction or gradually decreases (saturates) with increasing distance therefrom in the lateral direction, and such a change in slope can reduce stress due to external pressure while improving structural stability.

The curved region of the neck x40b, as shown in FIG. 7, can distribute physical stress (e.g., stress due to heat, pressure, and the like) that can be concentrated on a point where the body x40a and the spacer x40c meet, can improve durability, and can reduce lens detachment or delamination between the spacer x40c and the substrate x10 due to sudden changes in ambient temperature. Furthermore, this structure provides an advantage of changing the light path inside the spacer x40c to reduce trapping or loss of light inside the spacer x40c, thereby improving luminous efficacy.

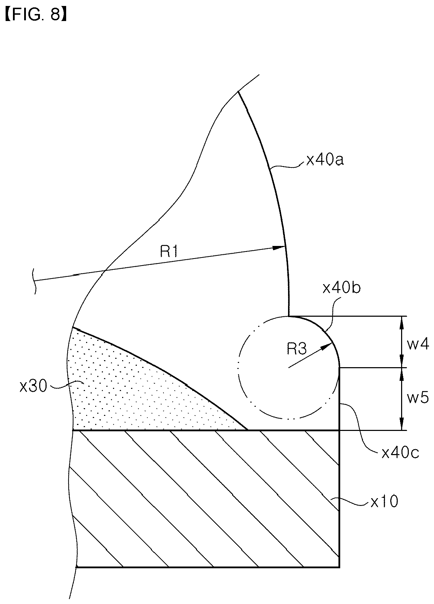

In another example, referring to FIG. 8, the inclined region of the neck x40b may include a region of a convexly curved shape. Although FIG. 8 illustrates a convexly curved shape formed over the entire inclined region of the neck x40b, it should be understood that the present invention is not limited thereto and the convexly curved shape may be formed over a region of the inclined region of the neck x40b. Although FIG. 8 shows that the convexly curved shape of the inclined region of the neck x40b has a single radius of curvature R3, it should be understood that the present invention is not limited thereto. For example, the convexly curved shape of the inclined region may include one or more radii of curvature within a certain range from R3. For example, the light emitting source 120/body x40a may include a region where the slope gradually decreases (saturates) with increasing distance from the center of the light emitting source 120/body x40a in the lateral direction or gradually increases with decreasing distance thereto in the lateral direction. The convexly curved region of the neck x40b, as shown in FIG. 8, can distribute physical stress (e.g., stress due to heat, pressure, and the like) that can be concentrated on the point where the body x40a meets the spacer x40c, can improve durability, and can reduce lens detachment or delamination between the spacer x40c and the substrate x10 due to sudden change in ambient temperature. Furthermore, this structure provides an advantage of changing the light path inside the spacer x40c to reduce trapping or loss of light inside the spacer x40c, thereby improving luminous efficacy.

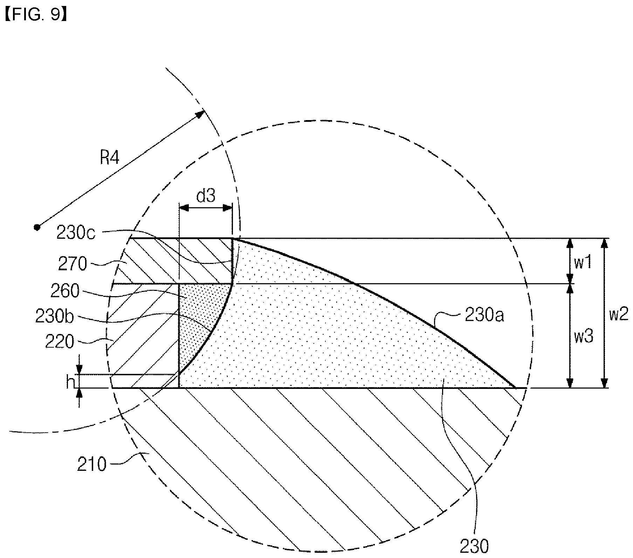

Referring to FIGS. 9, 10 and/or 11, examples of the side light extractor 260 and the reflector 230 applicable to the light emitting device 20 will be described.

The side light extractor 260 may include an inclined region on one surface thereof adjoining the reflector 230. The inclined region of the side light extractor 260 may include a predetermined curvature, specifically a curved surface having a radius of curvature R4.

According to one embodiment of the present invention, the radius of curvature R4 of the side light extractor 260 may be different from the radius of curvature R1 of the body 240a of the front-light extractor 240. For example, the radius of curvature R4 of the side light extractor 260 may be less than the radius of curvature R1 of the body 240a of the front-light extractor 240 to adjust the light path such that light can be emitted toward the front-light extractor to increase light extraction efficiency. The curved inclined region of the side light extractor 260 may have a greater curvature than the curvature of the body 240a of the front-light extractor 240. With the radius of curvature R4 less than the radius of curvature R1, the side light extractor 260 can improve efficiency in extraction of light emitted from the side region of the light emitting source 220 and can change the light traveling path of lateral light towards the wavelength conversion layer 270, thereby minimizing light loss to the side region of the light emitting source 220 while minimizing lateral light emitted without wavelength conversion. As a result, the light emitting device 20 can improve color uniformity of final light emitted therefrom. Furthermore, the light emitting device 20 can improve the quality of light while reducing the incidence of color distortion of a subject by reducing a difference in color temperature depending on the direction of irradiation and the direction of observing light.

If the radius of curvature R4 is greater than the radius of curvature R1, the light path of lateral light emitted from the light emitting source 220 can excessively extend to reduce the conversion rate of the wavelength conversion layer 270, which converts the irradiation direction of lateral light, causing deterioration in extraction efficiency of front light. Moreover, a fraction of the lateral light can be emitted from the light emitting device 20 without being subjected to wavelength conversion, causing deterioration in color uniformity of final light emitted from the light emitting device 20 depending on an exit angle of the final light.

According to one embodiment of the present invention, the radius of curvature R4 of the side light extractor 260 may be different from the radius of curvature R2 of the first reflective surface 230a of the reflector 230. For example, the radius of curvature R4 of the side light extractor 260 may be less than the radius of curvature R2 of the reflector 230. The curved inclined region of the side light extractor 260 may have a greater curvature than the first reflective surface 230a of the reflector 230. With the radius of curvature R4 less than the radius of curvature R2, the side light extractor 260 can improve efficiency in extraction of light emitted from the side region of the light emitting source 220 and can change the light traveling path of lateral light towards the wavelength conversion layer 270, thereby minimizing light loss to the side region of the light emitting source 220 while minimizing lateral light emitted without wavelength conversion. As a result, the light emitting device 20 can improve color uniformity of final light emitted therefrom. Furthermore, the light emitting device 20 can improve the quality of light while reducing the incidence of color distortion of a subject by reducing a difference in color temperature depending on the direction of irradiation and the direction of observing light.

If the radius of curvature R4 is greater than the radius of curvature R2, the light traveling path of lateral light emitted from the light emitting source 220 can excessively extend to reduce the conversion rate of the wavelength conversion layer 270, which converts the irradiation direction of lateral light, causing deterioration in efficiency of front-light extraction. Moreover, a fraction of the lateral light can be emitted from the light emitting device 20 without being subjected to wavelength conversion, causing deterioration in color uniformity of final light emitted from the light emitting device 20.

Although the side light extractor 260 is shown as having a single radius of curvature R4, it should be understood that the present invention is not limited thereto. For example, the side light extractor 260 may have one or more radii of curvature disposed within a certain range from R4, whereby the light path can be diversified to adjust the beam angle.

The inclined region of the side light extractor 260 may be formed in a region between the upper surface of the substrate and the lower surface of the wavelength conversion layer 270. The inclined region of the side light extractor 260 may be formed in a region between the upper surface of the substrate and a point separated a distance w3 from the upper surface of the substrate.

For example, assuming that the inclined region of the side light extractor 260 starts at the upper surface of the substrate, the inclined region of the side light extractor 260 may have a thickness w3.

If the inclined region of the side light extractor 260 starts at a point spaced apart a distance h from the upper surface of the substrate, the thickness of the inclined region of the side light extractor 260 may be w3-h. Preferably, h has a value less than 1/5 of the thickness w3 of the light emitting source 220 to improve efficiency in extraction of side emitting light. Preferably, h ranges from 1 % to 10% of w3 to improve light intensity by reducing loss of lateral light. In addition, h may be less than the height of an active region of a semiconductor layer of the light emitting source 220 with reference to the upper surface of the substrate.

The side light extractor 260 may have a thickness d3 and a light transmission path length in the lateral direction thereof. By way of example, the thickness d3 may be (d2-d1)/2. For details of d1 and d2, refer to the following description.

Referring to FIG. 2 and FIG. 3, in a cross-sectional view of the light emitting device 20, the side light extractor 260 disposed at one side of the light emitting source 220 may have a first thickness d3a, which is the maximum thickness in a direction parallel to the substrate, and the side light extractor 260 disposed at the other side of the light emitting source 220 may have a second thickness d3b, which is the maximum thickness in the direction parallel to the substrate. Here, a difference between the first thickness d3a and the second thickness d3b of the side light extractor 260 may be about 10%, and specifically, may be 10% or less and a uniform light emission path at both sides of the light emitting source 220, thereby improving color purity while reducing chromatic aberration. By way of example, the first thickness d3a and the second thickness d3b of the side light extractor 260 may have different widths. When the first thickness d3a and the second thickness d3b of the side light extractor 260 have different widths, a beam orientation pattern of the light emitting source 220 having an asymmetrical light emission area can be adjusted to become symmetrical, thereby reducing a difference in orientation pattern caused by light unevenness of the light emitting source 220. Further, when the first thickness d3a and the second thickness d3b of the side light extractor 260 have different widths, the orientation pattern of the light emitting source 220 having an asymmetrical area on one surface thereof can be adjusted to become symmetrical, thereby reducing a difference in orientation pattern caused by light unevenness of the light emitting source 220. Furthermore, the side light extractor 260 includes a first side light extractor disposed at one side of the light emitting source 220 and a second side light extractor disposed at the other side of the light emitting source 220, in which a difference between the maximum heights of the first side light extractor and the second side light extractor from the substrate 210 may be about 10%, specifically may be 10% or less, to provide a uniform light emission path at both sides of the light emitting source 220, thereby improving color purity while reducing chromatic aberration.

As described above, the reflector 230 may surround at least a region of the light emitting source 220 and the side light extractor 260. The reflector 230 may extend from the upper surface of the substrate 210 to adjoin at least a region of one side region of the wavelength conversion layer 270. The reflector 230 may be spaced apart from the light emitting source 220 while adjoining one side region of the side light extractor 260. More specifically, the reflector 230 may adjoin the curved surface of the side light extractor 260. The reflector 230 reflects light emitted from the light emitting source 220 to the outside of the light emitting device 20. At least a fraction of light emitted from the light emitting source 220 can reach the surface of the reflector 230 due to reflection inside the light emitting device 20 and the reflector 230 can reflect such light towards the front-light extractor 240 and can adjust the beam angle of light emitted from the light emitting device 20, thereby improving light extraction efficiency of the light emitting device 20. Further, the reflector 230 can adjust the path of lateral light emitted from the light emitting source 220 to face the front-light extractor 240. Accordingly, light emitted from the light emitting device 20 can increase uniformity of light depending on the beam angle. The reflector 230 may have a light reflectivity of 70% or more for light emitted from the light emitting source 220. For example, the reflector 230 may have a light reflectivity of 80% or more for light in the visible spectrum. In addition, the reflector 230 may have a light reflectivity of 90% or more for light in the blue wavelength band, without being limited thereto. The reflector 230 may be formed of a material having light reflectivity for light emitted from the light emitting source 220. The reflector 230 may include an organic polymer compound, such as a silicone resin, an epoxy or fluoropolymer resin, and the like, and may further include various additives, such as $TiO_2$, $Ba_2Ti_9O_{20}$, $BaSO_4$, $SiO_2$, $CaCO_3$, ZnO, $CaCO_3$, and the like, to improve light reflectivity.

The reflector 230 may at least partially adjoin the side region of the light emitting source 220. The reflector 230 may form a wall/hill surrounding the side region of the light emitting source 220. By way of example, the wall/hill formed by the reflector 230 may be partially spaced apart from the side region of the light emitting source 220 (while partially adjoining the side region thereof), thereby allowing the beam angle to be adjusted.

The reflector 230 may include a plurality of reflective surfaces. For example, the reflector 230 may include a first reflective surface 230a and a second reflective surface 230b. The first reflective surface 230a and the second reflective surface 230b may have different curvatures. The first reflective surface 230a and the second reflective surface 230b may have different radii of curvature. More preferably, the radius of curvature of the first reflective surface 230a is greater than the radius of curvature of the second reflective surface 230b. The curvature of the first reflective surface 230a may be less than the curvature of the second reflective surface 230b. The first reflective surface 230a and the second reflective surface 230b may form different reflection angles for light emitted from the light emitting source 220. The first reflective surface 230a and the second reflective surface 230b may form different incidence angles for light emitted from the light emitting source 220. The first reflective surface 230a may include a reflective surface that reflects light subjected to total reflection in the front-light extractor 240 and the second reflective surface 230b may include a reflective surface that reflects lateral light of the light emitting source 220, thereby improving light extraction efficiency through reduction in reabsorption of light using different reflection angles.

The second reflective surface 230b may adjoin at least one surface of the side light extractor 260. The first reflective surface 230a may also adjoin the front-light extractor 240. By forming the first reflective surface 230a and the second reflective surface 230b, the reflector 230 can improve efficiency in extraction of light emitted from the light emitting source 220 while improving efficiency in extraction of front light by re-reflecting the light reflected within the front-light extractor 240. By way of example, the first reflective surface 230a and the second reflective surface 230b of the reflector 230 may form an asymmetrical shape. Laterally, the thicknesses d3a, d3b of the second reflective surface 230b of the reflector 230 may be smaller than the maximum thickness of the first reflective surface 230a of the reflector 230 and may have a narrow reflection angle to adjust the light path such that lateral light can be incident on the wavelength conversion layer 270, thereby reducing chromatic aberration.

By way of example, in the cross-sectional view of FIG. 2 or FIG. 3, when the reflectors 230 formed at both sides of the light emitting source 220 are referred to as a first reflector 230-1 and a second reflector 230-2, respectively, the first reflector 230-1 and the second reflector 230-2 may be formed to have different widths with reference to an imaginary horizontal line from the upper surface of the substrate. When the first reflector 230-1 and the second reflector 230-2 have different widths, the beam angle of the light emitting source 220 having an asymmetrical light emission area can be adjusted to a target beam angle. In addition, when the first reflector 230-1 and the second reflector 230-2 have different widths, the beam angle of the light emitting source 220 having an asymmetrical area on one surface thereof can be adjusted to a target beam angle.

Referring to FIG. 9, the reflector 230 may include a linear region 230c adjoining the wavelength conversion layer 270. The linear region 230c may have a height corresponding to the thickness w1 of the wavelength conversion layer 270. The first reflective surface 230a of the reflector may include a curved surface or may include a linear region in at least a region thereof, in which the linear region may adjoin at least a region of the wavelength conversion layer 270 and may block light from a side region of the wavelength conversion layer to reduce chromatic aberration by blocking light subjected to excessive wavelength conversion while traveling in the lateral direction of the wavelength conversion layer. By way of example, the first reflective surface 230a of the reflector 230 forms an outwardly protruding curved surface. The first reflective surface 230a of the outwardly protruding curved surface may be flush with or higher than the upper surface of the wavelength conversion layer 270 in at least a region thereof to reduce light loss while improving light output by reflecting light from the side region of the wavelength conversion layer 270. By the outwardly protruding curved surface formed on the first reflective surface 230a of the reflector 230, the light emitting source 220 can prevent moisture penetration and coupling strength between the light emitting source 220 and the wavelength conversion layer 270 can be further increased, thereby improving reliability of the light emitting device 20. Accordingly, the reflector 230 can improve the lateral and front-light extraction efficiency of the light emitting source 220 and can adjust the beam angle of light emitted from the light emitting device 20 in a broad range. The second reflective surface 230b extends from the upper surface of the substrate 210 to a distal end of the linear region 230c and may adjoin the one side region of the wavelength conversion layer 270. The second reflective surface 230b may include a curved surface protruding outwards from the light emitting device 20, in which the protruding curved surface may have a radius of curvature R4. The radius of curvature R4 may be less than the radius of curvature R1 of the body 240a of the front-light extractor 240. When the radius of curvature R4 is less than the radius of curvature R1, the light emitting source 220 can secure improved efficiency in extraction of lateral light emitted therefrom.

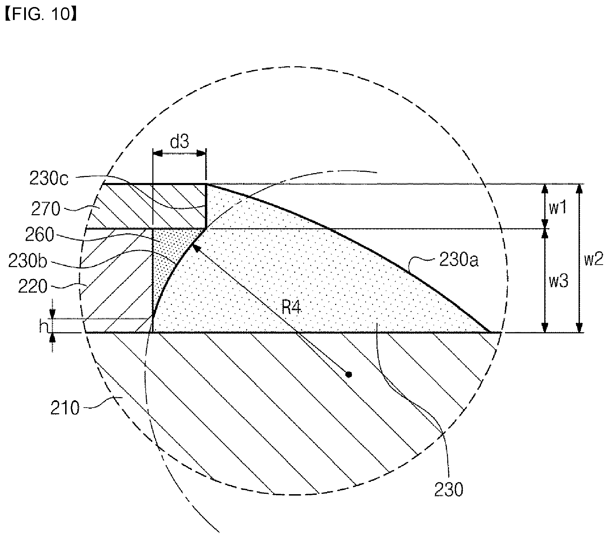

Referring to FIG. 10, the reflector 230 may include a linear region 230c adjoining the wavelength conversion layer 270. The linear region 230c may have a height corresponding to the thickness w1 of the wavelength conversion layer 270. The first reflective surface 230a of the reflector 230 may include a curved surface and may include a linear region in at least a region thereof, without being limited thereto. By way of example, the curved surface of the first reflective surface 230a may be flush with or lower than the upper surface of the wavelength conversion layer 270 in at least a region thereof. By forming the curved surface of the first reflective surface 230a of the reflector 230, it is possible to improve light extraction efficiency through improvement in reflection efficiency of the reflective layer on the upper surface of the substrate 210. Furthermore, the curved surface of the first reflective surface 230a can secure a front-light emission region of the light emitting source 220, thereby improving reliability of the light emitting device. Furthermore, the curved surface of the first reflective surface 230a can relieve stress caused by heat generated from the light emitting source 220, thereby improving reliability of the reflector 230 by preventing cracking of the reflector 230. Accordingly, the reflector 230 can improve the lateral and front-light extraction efficiency of the light emitting source 220 and can adjust the beam angle of light emitted from the light emitting device 20. The second reflective surface 230b adjoins the side light extractor 260 and the wavelength conversion layer 270, and extends from the upper surface of the substrate 210 to the distal end of the linear region 230c. A curved region of the second reflective surface 230b may include a curved surface that protrudes towards the side light extractor 260 adjoining the reflector 230. The protruding curved surface of the second reflective surface 230b may have a radius of curvature R4. The radius of curvature R4 may be less than the radius of curvature R1 of the first curved shape of the front-light extractor 240. When the radius of curvature R4 is less than the radius of curvature R1, the light emitting source 220 can secure improved efficiency in extraction of lateral light emitted therefrom.

On the other hand, referring to FIG. 11, a light transmission layer 220c may be disposed between the light emitting semiconductor device 220a and the wavelength conversion layer 270. Light transmittance of the light transmission layer 220c may correspond to light transmittance of the side light extractor 260. By way of example, the light transmittance of the light transmission layer 220c may be substantially the same as the light transmittance of the side light extractor 260. To this end, the light transmission layer 220c and the side light extractor 260 may be formed (together) of the same material. The light transmission layer 220c may increase the coupling strength between the light emitting source 220 and the wavelength conversion layer 270. Further, the light transmission layer 220c may cover the upper surface of the light emitting source 220 to protect the light emitting source 220 from an external environment. Specifically, the light transmission layer 220c can prevent the light emitting source 220 from being oxidized by external moisture. Furthermore, the light transmission layer 220c can prevent cracking of the wavelength conversion layer 270 by reducing stress caused by heat generated from the light emitting source 220. Furthermore, the light transmission layer 220c can improve reliability of the light emitting device by preventing deterioration of the wavelength conversion layer 270 due to heat generated from the light emitting source 220.

Although the inclined region of the first reflective surface 230a is shown as including a convex shape in FIG. 9 to FIG. 11 for convenience of description, it should be understood that the present invention is not limited thereto and the inclined region of the first reflective surface 230a may include a concave shape, for example, as shown in FIG. 3.

Referring to FIG. 3 to FIG. 5, assuming that the light emitting source 220 has a rectangular shape in plan view, one or more sides of the light emitting source 220 may have a length d1. As described above, the length d1 may be related to the length of a single light emitting semiconductor device or may be the sum of lengths of one or more light emitting semiconductor devices and a distance between the light emitting semiconductor devices. For example, when the light emitting source 220 includes a single light emitting semiconductor device, the length d1 may be in the range of 400 $\mu$m to 4,000 $\mu$m. When the light emitting source 220 includes a plurality of light emitting semiconductor devices 220a, as shown in FIG. 4 or FIG. 5, the length d1 satisfies a relationship: d1 ≥ d5 x the number of semiconductor devices + d6 x the number of semiconductor devices minus 1, and the distance between the light emitting semiconductor devices 220a can be secured to improve lateral light extraction efficiency of an overlapping region. Here, the number of semiconductor devices may be the number of semiconductor devices arranged on the same line as the length d1, d6 may be 0 or more, and the light extraction efficiency can be increased by minimizing interference between the semiconductor devices.

The wavelength conversion layer 270 may have various shapes, such as a square shape, a polygonal shape, a circular shape, or an elliptical shape, in plan view. For example, when the wavelength conversion layer 270 has a polygonal shape, the wavelength conversion layer 270 may include at least one side having a length d2, and when the wavelength conversion layer 270 has a circular or elliptical shape, the length d2 of the wavelength conversion layer 270 may be a diameter thereof. Further, when the wavelength conversion layer 270 includes one or more wavelength conversion members 270a, as shown in FIG. 5, the length d2 of the wavelength conversion layer 270 may represent the sum of lengths d7 of the wavelength conversion members 270a and a distance d8 therebetween.

The length d2 may be greater than the length d1 and may satisfy a relationship: d1 x c1 < d2 < d1 x c2. For example, c1 may be about 1.1, c2 may be about 1.7, and interference between the semiconductor devices can be minimized to improve light extraction efficiency.

The values d1 and d2 and the ratio between these values are important factors affecting luminous efficacy of the light emitting source 220. According to one embodiment, d2 may be set to 110% to 130% (e.g., 120%) of d1. For example, when d1 is 1,550 $\mu$m, d2 may be 1,700 $\mu$m.

Next, examples of the thickness w1 (e.g., light transmission path length of the wavelength conversion layer 270) and the particle size of the wavelength conversion layer 270 (applicable to the light emitting device 20) will be described.

In design of the wavelength conversion layer 270, high light transmittance and low refractivity are necessary for light extraction efficiency. For example, the wavelength conversion layer 270 may have a light transmittance of 90% or more and a low refractive index of 2.0 or less.

On the other hand, for light transmission efficiency, it is advantageous for the wavelength conversion layer 270 to have a thin thickness w1. However, if the thickness w1 becomes excessively thin, there are disadvantages in that the particle size of the particles that can be accommodated in the wavelength conversion layer 270 is limited and wavelength conversion performance is degraded.

In one example to address these problems, the particle size of the particles (e.g., phosphor particles) included in the wavelength conversion layer 270 may be determined based on the size of the wavelength conversion layer 270, for example, the thickness w1 (e.g., light transmission path length). Such a particle size can improve light extraction/light conversion efficiency and color uniformity.

By way of example, the thickness w1 of the wavelength conversion layer 270 may be selected in the range of 80 $\mu$m to 120 $\mu$m. The first type of particles may be YAG or LuAG particles having a particle size of 10 $\mu$m to 30 $\mu$m, and the second type of particles may be CASN or s-CASN particles having a particle size of 5 $\mu$m to 25 $\mu$m. By way of example, the second type of particles may be 5 $\mu$m to 25 $\mu$m KSF particles.

More specifically, when the thickness w1 of the wavelength conversion layer 270 is 110 $\mu$m, the first type of particles may be YAG or LuAG particles having a particle size of 15 $\mu$m to 30 $\mu$m, and the second type of particles may be CASN or s-CASN particles having a particle size of 10 $\mu$m to 25 $\mu$m. By way of example, the second type of particles may be 10 to 25 $\mu$m KSF particles.

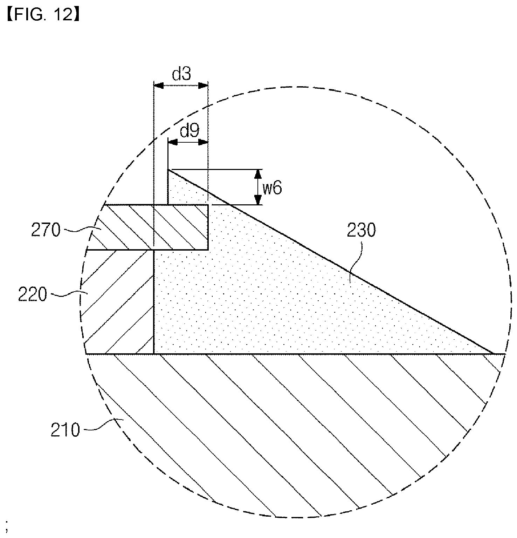

Although the maximum thickness of the reflector 230 from the upper surface of the substrate 210 is illustrated as w2 or w1+w3 in the above description, it should be understood that the present invention is not limited thereto and the maximum thickness of the reflector 230 may be greater than w2 or w1 +w3 in the above examples. For example, as shown in FIG. 12, the reflector 230 may include a region that is thicker than the upper surface of the wavelength conversion layer 270 by w6. For example, the maximum thickness of the reflector 230 may be w2+w6. Furthermore, the reflector 230 may cover the upper surface of the wavelength conversion layer 270 at one side thereof by a length d9. In this way, when the reflector 230 covers the upper surface of the wavelength conversion layer 270, the moisture penetration path is lengthened, thereby protecting the light emitting source 220 from external moisture while improving reliability under high temperature/high humidity environments. Furthermore, this structure can form a narrower beam angle of light as needed, can adjust the light path through the wavelength conversion layer 270, and can ensure that light emitted from the light emitting source 220 passes through the wavelength conversion layer 270 along the same path, thereby improving quality of light by reducing chromatic aberration depending on the light observation angle. In this case, the length d2 may be less than or equal to d1 to amplify the effects described above.

Furthermore, in the above examples, the light emitting source 220 may include at least one of a roughness structure 220a-1 or a deposition layer 220a-2 covering at least a region of the roughness structure 220a-1 inside the light emitting source 220, as shown in FIG. 7, and in some embodiments, the deposition layer 220a-2 or the roughness structure 220a-1 may be omitted. By way of example, the roughness structure 220a-1 may be a patterned sapphire substrate (PSS), a patterned sapphire substrate LED with an $Si_3N_4$ barrier (PSN), a patterned sapphire substrate LED with an $SiO_2$ barrier (PSO), patterned sapphire with air void (PSA), or the like. By way of example, the deposition layer 220a-2 may be formed through plasma-enhanced chemical vapor deposition (PECVD). Specifically, the deposition layer 220a-2 may be an $SiO_2$, $Si_3N_4$, or AlN layer formed through PECVD. The roughness structure 220a-1 and the deposition layer 220a-2 can improve luminous efficacy by (re)reflecting light emitted/absorbed toward the lower surface of the light emitting source 220 to the upper surface of the light emitting source 220. In particular, such a structure can improve light extraction efficiency (LEE) by 5% or more. On the other hand, the roughness structure 220a-1 and the deposition layer 220a-2 are not limited to the shapes shown in FIG. 13 and may be replaced by various other shapes, such as an irregular shape, a serrated shape, a conical shape, a trapezoidal shape, a concave shape, and the like.

The detailed description of the exemplary embodiments of the present invention disclosed herein has been provided to allow those skilled in the art to implement and practice the present invention. Although some exemplary embodiments have been described herein with reference to the accompanying drawings, it should be understood that various modifications and changes can be made by those skilled in the art without departing from the spirit and scope of the invention, as defined by the claims and equivalents thereto. For example, those skilled in the art may utilize each of the configurations described in the above embodiments through combination with each other.

Accordingly, the present invention is not intended to be limited to the embodiments disclosed herein, but rather to give the broadest scope consistent with the principles and novel features disclosed herein.

[List of Reference Numerals]

> 20: Light emitting device
> 210: Substrate
> 220: Light emitting source
> x30, 230: Reflector
> x40, 240: Front-light extractor
> 250: Electrode
> 260: Side light extractor
> 270: Wavelength conversion layer

**Claims**

1. A light emitting device comprising:

> a light emitting source comprising a light emitting semiconductor device;
> a reflector disposed on a side region of the light emitting source while at least partially adjoining the side region of the light emitting source;
> a front-light extractor disposed on the light emitting source and the reflector and including a first curved shape;
> a wavelength conversion layer disposed in at least a region on a light path of the light emitting source;

a substrate on which the light emitting source, the reflector, and the front-light extractor are disposed; and
a side light extractor disposed between the light emitting source and the reflector,
wherein the side light extractor includes a second curved shape on one surface thereof and a maximum radius of curvature of the second curved shape is less than a radius of curvature of the first curved shape of the front-light extractor.

2. The light emitting device according to claim 1, wherein a distance from an upper surface of the wavelength conversion layer to an apex of the first curved shape corresponds to the radius of curvature of the first curved shape.

3. The light emitting device according to claim 1 or 2, wherein the wavelength conversion layer is a film or sheet type and a thickness deviation of the wavelength conversion layer on an upper surface of the light emitting source is less than 10%.

4. The light emitting device according to one of the preceding claims, wherein a side region of the light emitting source includes a length d1 in a lateral direction and the wavelength conversion layer includes a length d2 in the lateral direction, the length d1 being less than or equal to the length d2.

5. The light emitting device according to claim 4, wherein a ratio of a region of the wavelength conversion layer to a region of the light emitting source is 150% or less.

6. The light emitting device according to one of the preceding claims, wherein light emitted from the light emitting source has a first wavelength band and the wavelength conversion layer includes a first type of particles converting a fraction of light having a wavelength in the first wavelength band into light having a wavelength in a second wavelength band, wavelengths in the first wavelength band being shorter than wavelengths in the second wavelength band.

7. The light emitting device according to claim 6, wherein the wavelength conversion layer further includes a second type of particles converting a fraction of light having a wavelength in the first wavelength band into light having a wavelength in a third wavelength band, wavelengths in the third wavelength band being longer than wavelengths in the second wavelength band.

8. The light emitting device according to one of the preceding claims, wherein the side light extractor has a higher transmittance than the reflector.

9. The light emitting device according to one of the preceding claims , wherein:

the side light extractor comprises a first side light extractor disposed at a side of the light emitting source and a second side light extractor disposed at the other side of the light emitting source; and
a difference between a maximum height of the first side light extractor from the substrate and a maximum height of the second side light extractor from the substrate is less than 10%.

10. The light emitting device according to one of the preceding claims, wherein the side light extractor has a maximum thickness not exceeding a thickness of the light emitting source.

11. The light emitting device according to one of the preceding claims, wherein the reflector comprises a first reflective surface adjoining at least a surface of the front-light extractor and a second reflective surface adjoining at least a surface of the side light extractor, the first and second reflective surfaces being asymmetrical.

12. The light emitting device according to claim 11, wherein a maximum thickness of the second reflective surface from an upper surface of the substrate is less than a maximum thickness of the first reflective surface.

13. The light emitting device according to claim 11 or 12, wherein at least a region of the first reflective surface is flush with or higher than an upper surface of the wavelength conversion layer.

14. The light emitting device according to one of the preceding claims, wherein the reflector comprises a linear region adjoining the wavelength conversion layer, the liner region having a height corresponding to a thickness of the wavelength conversion layer.

15. The light emitting device according to one of the preceding claims, wherein the reflector comprises a first reflector formed at a side of the light emitting source and a second reflector formed at the other side of the light emitting source,
the first reflector and the second reflector having different widths with reference to an imaginary horizontal line from the upper surface of the substrate.

【FIG. 1】

【FIG. 2】

20

【FIG. 3】

【FIG. 4】

【FIG. 5】

【FIG. 6】

【FIG. 7】

【FIG. 8】

【FIG. 9】

【FIG. 10】

【FIG. 11】

【FIG. 12】

【FIG. 13】

Europäisches
Patentamt

European
Patent Office

Office européen
des brevets

# EUROPEAN SEARCH REPORT

Application Number

EP 24 17 2210

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 342 486 B2 (SUZHOU LEKIN SEMICONDUCTOR CO LTD [CN]) 24 May 2022 (2022-05-24) * column 5, line 60 - column 12, line 60 * * figures 2,6 * | 1-15 | INV. H01L33/54 H01L33/60 H01L33/50 |
| X | JP 2015 173287 A (NICHIA KAGAKU KOGYO KK) 1 October 2015 (2015-10-01) * figures 1,5 * | 1-3 | |
| X | US 9 922 963 B2 (GENESIS PHOTONICS INC [TW]) 20 March 2018 (2018-03-20) * figures 1,3 * | 1-3,13 | |
| A | US 8 294 173 B2 (CHEN WEI-AN [TW]; FAN CHU-PING [TW]; LEXTAR ELECTRONICS CORP [TW]) 23 October 2012 (2012-10-23) * figure 2 * | 1 | |

TECHNICAL FIELDS
SEARCHED      (IPC)

H01L

The present search report has been drawn up for all claims

| Place of search | Date of completion of the search | Examiner |
|---|---|---|
| The Hague | 17 September 2024 | Gijsbertsen, Hans |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 2210

This annex lists the patent family members relating to the patent documents cited in the above-mentioned European search report.
The members are as contained in the European Patent Office EDP file on
The European Patent Office is in no way liable for these particulars which are merely given for the purpose of information.

17-09-2024

| Patent document cited in search report | | Publication date | Patent family member(s) | | Publication date |
|---|---|---|---|---|---|
| US 11342486 | B2 | 24-05-2022 | US | 2020335673 A1 | 22-10-2020 |
| | | | WO | 2019088704 A1 | 09-05-2019 |
| JP 2015173287 | A | 01-10-2015 | JP | 6020657 B2 | 02-11-2016 |
| | | | JP | 2015173287 A | 01-10-2015 |
| US 9922963 | B2 | 20-03-2018 | CN | 106549092 A | 29-03-2017 |
| | | | CN | 111211206 A | 29-05-2020 |
| | | | CN | 111223975 A | 02-06-2020 |
| | | | US | 2017084587 A1 | 23-03-2017 |
| | | | US | 2018211942 A1 | 26-07-2018 |
| | | | US | 2020105725 A1 | 02-04-2020 |
| US 8294173 | B2 | 23-10-2012 | TW | 200932035 A | 16-07-2009 |
| | | | US | 2010301357 A1 | 02-12-2010 |

EPO FORM P0459